(19) **Europäisches Patentamt**
**European Patent Office**
**Office européen des brevets**

(11) **EP 3 617 675 B1**

(12) **EUROPEAN PATENT SPECIFICATION**

(45) Date of publication and mention
of the grant of the patent:
**20.08.2025 Bulletin 2025/34**

(21) Application number: **19165789.9**

(22) Date of filing: **28.03.2019**

(51) International Patent Classification (IPC):
**G01J 3/28** *(2006.01)* **G01J 3/02** *(2006.01)*
**G02B 5/22** *(2006.01)* **G02B 5/24** *(2006.01)*
**G02B 1/06** *(2006.01)* **G01J 3/12** *(2006.01)*
**H10F 77/40** *(2025.01)*

(52) Cooperative Patent Classification (CPC):
**G01J 3/2803; G01J 3/0259; G02B 1/06;**
**G02B 5/24; H10F 77/407;** G01J 2003/1213

(54) **SPECTROMETER INCLUDING AN IMAGE SENSOR HAVING A LIGHT FILTER**

SPEKTROMETER MIT BILDSENSOR UND LICHTFILTER

SPECTROMÈTRE COMPRENANT UN CAPTEUR D'IMAGE AVEC FILTRE DE LUMIÈRE

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **31.08.2018 KR 20180104014**

(43) Date of publication of application:
**04.03.2020 Bulletin 2020/10**

(73) Proprietor: **Samsung Electronics Co., Ltd.**
**Suwon-si, Gyeonggi-do, 16677 (KR)**

(72) Inventors:
• **CHO, Kyungsang**
**16678 Gyeonggi-do (KR)**

• **BAIK, Chanwook**
**16678 Gyeonggi-do (KR)**

(74) Representative: **Grünecker Patent- und**
**Rechtsanwälte**
**PartG mbB**
**Leopoldstraße 4**
**80802 München (DE)**

(56) References cited:
**US-A- 3 610 740 US-B1- 6 573 988**

• **JIE BAO ET AL: "A colloidal quantum dot**
**spectrometer", NATURE, vol. 523, no. 7558, 1**
**July 2015 (2015-07-01), London, pages 67 - 70,**
**XP055465070, ISSN: 0028-0836, DOI: 10.1038/**
**nature14576**

**Description**

BACKGROUND

1. Field

The disclosure relates to light filters and spectrometers including the light filters.

2. Description of the Related Art

A small spectrometer may be easily carried around due to its compact size. Such spectrometer can be applied to various devices, e.g., biosensors and portable gas sensors. However, it is difficult to use a spectroscopic method based on a grating structure in the case of the small spectrometer. Document US6573988B1 is directed to a cuvette and spacer therefore as well as method of producing the spacer. The cuvette has two opposing windows made of a material, which is transparent to the light of the waveband used for the analysis, said windows defining a limited light path of a light beam passing through a cavity inside the cuvette. The window surfaces forming the cuvette cavity are non parallel, thereby ensuring that the internal distances between opposed areas of the windows surfaces will vary across the transparent windows.

SUMMARY

The invention is described in the claims. The invention provides a spectrometer according to claim 1. Preferred embodiments are described in the dependent claims. The embodiments which do not fall within the scope of the claims are to be interpreted as examples useful for a better understanding of the invention. Provided are spectrometers including light filters.

Additional aspects will be set forth in part in the description which follows and, in part, will be apparent from the description, or may be learned by practice of the embodiments of the disclosure.

According to an aspect of the disclosure, there is provided a light filter comprising: at least one filter, wherein the at least one filter comprises a liquid spectrum modulation layer having different transmittance spectra according to different positions on the at least one filter.

The liquid spectrum modulation layer has different thicknesses according to the different positions on the at least one filter. The thickness of the liquid spectrum modulation layer can be easily adjusted.

The at least one filter further comprises a filter frame comprising an inner space filled with the liquid spectrum modulation layer, wherein the filter frame is formed of an optically transparent material.

The filter frame may comprise glass, quartz, or polymer.

The inner space of the filter frame may comprise a triangular, trapezoidal, or lens shaped cross section.

The liquid spectrum modulation layer comprises a solution comprising a light absorption modulation material. Therefore, the liquid spectrum modulation layer may not reflect light or cause scattering.

The light absorption modulation material may comprise at least one of quantum dots (QDs), inorganic materials, or polymers.

The different transmittance spectra may have a non-linear relation.

The light filter may further comprising an anti-reflection layer provided on at least one of an upper surface and a lower surface of the at least one filter.

The at least one filter may further comprise a plurality of filters, wherein each of the plurality of filters may comprise a respective liquid spectrum modulation layer, and wherein the plurality of filters maybe arranged in an array on a same plane.

The respective liquid spectrum modulation layers of the plurality of filters may have different types of light absorption modulation materials or different sizes of light absorption modulation materials.

The at least one filter may further comprise a plurality of filters, wherein each of the plurality of filters may comprise a respective liquid spectrum modulation layer, and wherein the plurality of filters maybe arranged in a vertically overlapping form.

The respective liquid spectrum modulation layers of the plurality of filters may have different types of light absorption modulation materials or different sizes of light absorption modulation materials.

Ratios of the light absorption modulation materials at the different positions of the light filter maybe different according a characteristic of overlapping filters, among the plurality of overlapping filters, at the different positions of the light filter.

The at least one filter may further comprise a plurality of filters, wherein each of the plurality of filters may comprise a respective liquid spectrum modulation layer, and wherein the plurality of filters maybe arranged in an array on a same plane and are arranged in a vertically overlapping form.

According to the claimed invention, there is provided a spectrometer comprising: a light filter comprising at least one filter; and a sensor configured to receive light transmitted through the light filter, wherein the at least one filter comprises a liquid spectrum modulation layer having different transmittance spectra according to different positions on the at least one filter.

The liquid spectrum modulation layer has different thicknesses according to the different positions on the at least one filter.

The at least one filter further comprises a filter frame comprising an inner space filled with the liquid spectrum modulation layer, wherein the filter frame is formed of an optically transparent material.

The filter frame may comprises glass, quartz, or polymer.

The inner space of the filter frame may comprise a triangular, trapezoidal, or lens shaped cross section.

The liquid spectrum modulation layer comprises a solution comprising a light absorption modulation material.

The light absorption modulation material may comprise at least one of quantum dots (QDs), inorganic materials, or polymers.

The different transmittance spectra may have a non-linear relation.

The light filter may further comprise an anti-reflection layer provided on at least one of an upper surface and a lower surface of the at least one filter.

The at least one filter further comprises a plurality of filters, wherein each of the plurality of filters may comprise a respective liquid spectrum modulation layer, and wherein the plurality of filters maybe arranged in an array on a same plane.

The respective liquid spectrum modulation layers of the plurality of filters may have different types of light absorption modulation materials or different sizes of light absorption modulation materials.

The at least one filter may further comprises a plurality of filters, wherein each of the plurality of filters may comprise a respective liquid spectrum modulation layer, and wherein the plurality of filters maybe arranged in a vertically overlapping form.

The respective liquid spectrum modulation layers of the plurality of filters may have different types of light absorption modulation materials or different sizes of light absorption modulation materials.

Ratios of the light absorption modulation materials at the different positions of the light filter maybe different according a characteristic of overlapping filters, among the plurality of overlapping filters, at the different positions of the light filter.

The at least one filter may further comprise a plurality of filters, wherein each of the plurality of filters may comprise a respective liquid spectrum modulation layer, and wherein the plurality of filters maybe arranged in an array on a same plane and are arranged in a vertically overlapping form.

The sensor comprises an image sensor.

The spectrometer may have a resolution less than or equal to 1 nm.

According to another aspect of the disclosure, there is provided a light filter comprising: a filter frame; and a liquid spectrum modulation layer provided inside a cavity of the filter frame, wherein the filter frame has a first thickness at a first position on the filter frame and a second thickness at a second position on the filter frame according to different transmittance spectra.

The filter frame may comprise: a bottom portion and a top portion that form the cavity, wherein a distance between the bottom portion and the top portion may gradually changes according to different transmittance spectra.

One of the bottom portion and the top portion maybe inclined with respect to the other of the bottom portion and the top portion.

One of the bottom portion and the top portion maybe a concave shape or convex shape.

## BRIEF DESCRIPTION OF THE DRAWINGS

These and/or other aspects will become apparent and more readily appreciated from the following description of the embodiments, taken in conjunction with the accompanying drawings in which:

FIG. 1 is a perspective view showing a spectrometer according to an embodiment;
FIG. 2 is a cross-sectional view of the spectrometer shown in FIG. 1;
FIG. 3 is an enlarged view of a spectrum modulation layer of the spectrometer shown in FIG. 2;
FIG. 4A illustrates an example of an experimental model of a light filter;
FIG. 4B is a simulation result showing transmittance spectra of the light filter shown in FIG. 4A;
FIG. 5A illustrates another example of an experimental model of a light filter;
FIG. 5B is a simulation result showing transmittance spectra of the light filter shown in FIG. 5A;
FIG. 6 is a cross-sectional view illustrating a spectrometer according to another embodiment;

FIG. 7 is a cross-sectional view showing a light filter of a spectrometer according to another embodiment;

FIG. 8A is a plan view showing a light filter of a spectrometer according to another embodiment;

FIG. 8B is a cross-sectional view showing a light filter of a spectrometer according to another embodiment;

FIG. 9 is a perspective view showing a spectrometer according to another embodiment;

FIG. 10 is a cross-sectional view of the spectrometer shown in FIG. 9;

FIGS. 11A to 11C illustrate examples of an experimental model of a light filter;

FIGS. 12A and 12B are simulation results showing transmittance spectra of the light filter shown in FIGS. 11A to 11C;

FIGS. 13A to 13C illustrate other examples of an experimental model of a light filter;

FIGS. 14A and 14B are simulation results showing transmittance spectra of the light filter shown in FIGS. 13A to 13C;

FIG. 15 is a cross-sectional view of a spectrometer according to another embodiment;

FIG. 16 is a plan view showing a spectrometer according to another embodiment;

FIG. 17 is a plan view showing a spectrometer according to another embodiment;

FIGS. 18A and 18B show examples of an experimental model of a light filter;

FIG. 19 is a simulation result showing transmittance spectrums of a light filter shown in FIGS. 18A and 18B;

FIGS. 20A and 20B show comparisons between a reconstructed input spectrum and a real input spectrum from a result shown in FIG. 19;

FIGS. 21A to 21C illustrate other examples of an experimental model of a light filter;

FIG. 22 shows a simulation result showing transmittance spectra of light filters shown in FIGS. 11A to 11C;

FIGS. 23A and 23B show comparisons between a reconstructed input spectrum and a real input spectrum from a result shown in FIG. 22;

FIGS. 24A to 24C illustrate other examples of an experimental model of a light filter;

FIG. 25 shows a simulation result showing transmittance spectra of a light filter shown in FIGS. 24A to 24C; and

FIGS. 26A and 26B show comparisons between a reconstructed input spectrum and a real input spectrum from a result shown in FIG. 25.

## DETAILED DESCRIPTION

Reference will now be made in detail to embodiments, which are illustrated in the accompanying drawings, wherein like reference numerals refer to like elements throughout. Also, the size of each layer illustrated in the drawings may be exaggerated for convenience of explanation and clarity. In this regard, the embodiments may have different forms and should not be construed as being limited to the descriptions set forth herein.

In the following description, when a constituent element is disposed "above" or "on" to another constituent element, the constituent element may be only directly on the other constituent element or above the other constituent elements in a non-contact manner. As used herein, the singular forms "a," "an" and "the" are intended to include the plural forms as well, unless the context clearly indicates otherwise. It will be further understood that the terms "comprises" and/or "comprising" used herein specify the presence of stated features or components, but do not preclude the presence or addition of one or more other features or components.

The use of the terms "a" and "an" and "the" and similar referents in the context of describing the disclosure (especially in the context of the following claims) are to be construed to cover both the singular and the plural. Also, the steps of all methods described herein may be performed in any suitable order unless otherwise indicated herein or otherwise clearly contradicted by context. The disclosure is not limited to the described order of the steps. The use of any and all examples, or language (e.g., "such as") provided herein, is intended merely to better illuminate the disclosure and does not pose a limitation on the scope of the disclosure unless otherwise claimed.

A small spectrometer may be implemented by forming spectrum modulation layers having different transmittance spectra by adjusting a thickness of a light absorption modulation material such as quantum dots (QDs) or by adjusting a mixing ratio of different light absorption modulation materials may be used. In this case, to realize high resolution, it is necessary to form a precise and uniform spectrum modulation layer.

Generally, to form a solid spectrum modulation layer, a method of coating a solution including a light absorption modulation material for each pixel by using, for example, spin coating, dip coating, spray coating, inkjet printing, etc., and then drying the solution may be used.

However, methods such as spin coating, dip coating, spray coating and the like are not suitable for forming spectrum modulation layers of different thicknesses with only one coating. Specifically, to form spectrum modulation layers having thickness differences for each pixel, it is necessary to perform repetitive patterning several times. It is difficult to form spectrum modulation layers having precise thickness differences by such repetitive patterning.

In addition, the ink jet fritting method may form spectrum modulation layers of different thicknesses by dropping different amounts of ink droplets for each pixel. Here, the ink droplets include light absorption modulation materials. However, it is technically difficult to drop a precisely controlled amount of ink droplets to an exact position in a pixel having a micrometer size, and it is difficult to control the spectrum modulation layer to have a uniform thickness when the ink droplets are dried.

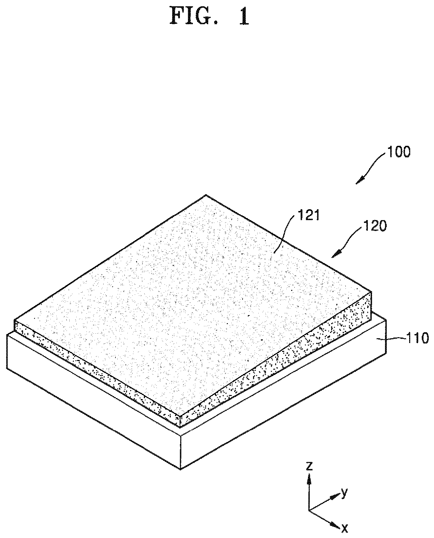

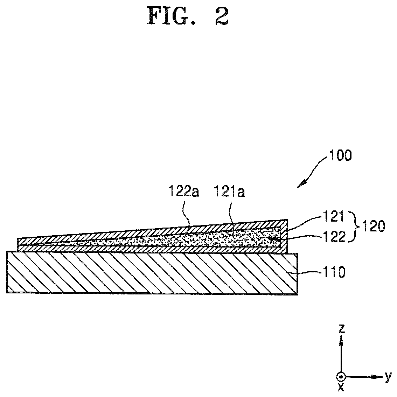

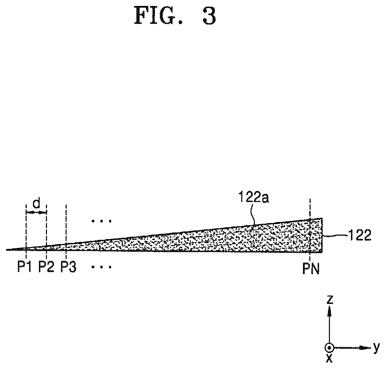

FIG. 1 is a perspective view showing a spectrometer 100 according to an embodiment. FIG. 2 is a cross-sectional view of the spectrometer 100 shown in FIG. 1. FIG. 3 is an enlarged view of a spectrum modulation layer 122 of the spectrometer 100 shown in FIG. 2.

Referring to FIGS. 1 to 3, the spectrometer 100 includes a sensing unit 110 and a light filter provided on the sensing unit 110. Here, the light filter includes a filter unit 120 having different transmittance spectra according to different positions on the light filter. Specifically, the filter unit 120 includes a filter frame 121 and the liquid spectrum modulation layer 122 provided inside the filter frame 121.

The filter frame 121 includes an optically transparent material. The filter frame 121 may include, for example, glass, quartz or, a polymer. Here, the polymer may include polydimethylsiloxane (PDMS), polycarbonate (PC), and the like, but is not limited thereto. The materials stated above are merely examples and the filter frame 121 may include various other materials. The filter frame 121 may have an optically flat surface such that no scattering occurs.

The filter frame 121 includes an inner space 121a filled with the liquid spectrum modulation layer 122. Here, the inner space 121a of the filter frame 121 may be formed at different heights according to positions on the light filter. For example, the inner space 121a of the filter frame 121 may have a triangular cross-section whose height gradually increases in a +y direction, as shown in FIG. 2.

The liquid spectrum modulation layer 122 is filled in the inner space 121a of the filter frame 121. Here, the liquid spectrum modulation layer 122 includes a solution in which a light absorption modulation material 122a is dispersed in a predetermined solvent. Here, the light absorption modulation material 122a refers to a material capable of forming a spectrum modulated by absorbing light. Such a light absorption modulation material 122a may include at least one of, for example, QDs, inorganic materials, and polymers.

The QDs may be semiconductor particles having a size of about several nanometers, and may include, for example, CdSe, CdS, PbSe, PbS, InAs, InP, or CdSeS, but this is merely an example. The QDs may include other various semiconductor materials. The QDs may have, for example, a core-shell structure, but is not limited thereto. The polymers may include, for example, poly (2-methoxy-5-(2-ethylhexyloxy)-1,4-phenylenevinylene) (MEH-PPV) or poly(3-hexylthiophene) (P3HT), but this is merely an example. The polymers may include other various organic materials. The inorganic materials may include, for example, a Group VI semiconductor material, a Group III-V compound semiconductor material, or a Group II-VI compound semiconductor material, but this is merely an example. The inorganic materials may include various other materials.

The liquid spectrum modulation layer 122 has a shape corresponding to the inner space 121a of the filter frame 121. Thus, the liquid spectrum modulation layer 122 has different thickness according to different positions on the light filter. For example, the liquid spectrum modulation layer 122 may have a triangular cross-sectional shape whose thickness gradually increases in the +y direction, as shown in FIG. 2.

Referring to FIG. 3, different N measurement positions P1, P2, P3,..., PN may be set in the liquid spectrum modulation layer 122. Here, the N measurement positions P1, P2, P3, ..., PN may include first, second, third, ..., Nth measurement positions P1, P2, P3, ..., PN respectively that are arranged at a regular distance d in a direction (i.e., the +y direction) in which the thickness of the spectrum modulation layer 122 increases.

As described above, the thickness of the spectrum modulation layer 122 may vary according to the measurement positions P1, P2, P3, ..., PN, and a thickness change of the spectrum modulation layer 122 may form different transmittance spectra. For example, as shown in FIG. 3, since the N measurement positions P1, P2, P3, ..., PN are set in the spectrum modulation layer 122, different N transmittance spectrums may be formed. These different transmittance spectra may have, for example, a non-linear relation.

The sensing unit 110 receives light transmitted through the filter unit 120, which is a light filter and may convert the light into an electrical signal. Light incident on the filter unit 120 may be transmitted through the liquid spectrum modulation layer 122 having different thicknesses according to measurement positions and reach pixels (not shown) of the sensing unit 110. The sensing unit 110 may convert light incident on the pixels into an electrical signal. The sensing unit 110 includes an image sensor such as a charge-coupled device (CCD) or a complementary metal-oxide semiconductor (CMOS) image sensor.

A spectrum input to the spectrometer 100 may be reconstructed using transmittance spectra of the liquid spectrum modulation layer 122 according to the measurement positions P1, P2, P3, ..., PN and signals of the sensing unit 110.

Specifically, the relationship between the transmittance spectra of the spectrum modulation layer 122 according to the measurement positions P1, P2, P3, ..., PN and signals of the sensing unit 110 may be defined by Equation 1.

$$\mathbf{r} = \mathbf{Hs} + \mathbf{n}, \quad \text{--------------} \quad (1)$$

where r denotes the signals of the sensing unit 110, H denotes a transmittance spectrum matrix of the spectrum modulation layer 122, s denotes a reconstructed input spectrum, and n denotes a noise value. According to an embodiment, r, H, S, and n may be defined in a matrix form as shown below. Herein, the transmittance spectrum matrix H may show transmittances based on wavelengths in the transmittance spectra of the measurement positions P1, P2, P3, ..., PN of the spectrum modulation layer 122 in a matrix form and may include values measured in a test. The transmittance spectrum matrix H may be calculated using known values of the input spectrum s based on wavelengths and the measured signals r.

$$\mathbf{r} = \begin{bmatrix} r_1 \\ \vdots \\ r_j \\ \vdots \\ r_N \end{bmatrix}, \ \mathbf{H} = \begin{bmatrix} D_1(\lambda_1) & \cdots & D_1(\lambda_M) \\ \vdots & \vdots & \vdots \\ D_j(\lambda_1) & \cdots & D_j(\lambda_M) \\ \vdots & \vdots & \vdots \\ D_N(\lambda_1) & \cdots & D_N(\lambda_M) \end{bmatrix}, \ \mathbf{s} = \begin{bmatrix} s(\lambda_1) \\ s(\lambda_2) \\ \vdots \\ \vdots \\ s(\lambda_M) \end{bmatrix}, \text{ and } \mathbf{n} = \begin{bmatrix} n_1 \\ n_2 \\ \vdots \\ \vdots \\ n_N \end{bmatrix}$$

(where $\lambda$ denotes a wavelength, N denotes the number of measurement positions, and M denotes the number of signals.)

When a parameter of the transmittance spectrum matrix H is determined in an initial test, the input spectrum s may be calculated using an inverse matrix of the transmittance spectrum matrix H of the spectrum modulation layer 122 and the signals r of the sensing unit 110. The value of the noise n may refer to dark noise caused in the sensing unit 110 and may be a small value that is normally negligible. To increase calculation accuracy, if necessary, a dark noise value measured in a darkroom environment may be used.

According to the embodiment, different transmittance spectra may be formed using the liquid spectrum modulation layer 122 having thicknesses varying according to the measurement positions P1, P2, P3, ..., PN, and an input spectrum may be calculated using the transmittance spectra. Meanwhile, the different transmittance spectra of the spectrum modulation layer 122 may increase the accuracy of the calculated input spectrum. For example, the different transmittance spectra may have a non-linear relation.

As described above, according to the embodiment, different transmittance spectra are formed using the liquid spectrum modulation layer 122 having thicknesses varying according to positions. For example, when 100 or more different transmittance spectra are generated within a wavelength range of about 100 nm, a spectrometer having a high resolution equal to or lower than about 1 nm may be implemented.

Also, the thickness of the spectrum modulation layer 122 may be easily adjusted by manufacturing the light filter using the filter frame 121 and the liquid spectrum modulation layer 122. Also, the thickness of the liquid spectrum modulation layer 122 may be precisely adjusted according to different positions on the light filter, and thus precisely modulated transmittance spectra may be obtained. Also, the filter frame 121 may have the optically flat surface that does not cause scattering, and the liquid spectrum modulation layer 122 may include the solvent that causes no scattering, and thus the spectrometer 100 having optically excellent characteristics may be implemented.

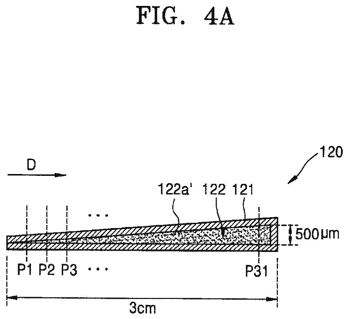

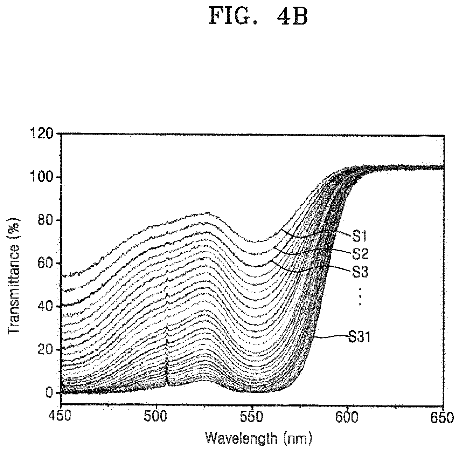

FIG. 4A illustrates an example of an experimental model of a light filter. FIG. 4B is a simulation result showing transmittance spectra of the light filter shown in FIG. 4A.

Referring to FIG. 4A, the liquid spectrum modulation layer 122 whose thickness varies according to different positions on the light filter is provided in an inner space of the filter frame 121. Here, the liquid spectrum modulation layer 122 may include a cyclohexane solution including a light absorption modulation material 122a' having a concentration of 3 wt% (weight percent). According to an embodiment, the light absorption modulation material 122a' maybe a QD having a maximum absorption wavelength of 561 nm. Such a liquid spectrum modulation layer 122 may have a triangular cross section whose thickness gradually increases in a D direction. In the spectrum modulation layer 122, the measurement positions P1, P2, P3, ..., P31 may be set at a regular distance in the D direction.

FIG. 4B shows 31 different transmittance spectra S1, S2, S3, ... S31 measured at the 31 measurement positions P1, P2, P3, ... P31 set at the regular distance along the D direction in the spectrum modulation layer 122 of FIG. 4A. In FIG. 4B, S1, S2 and S3 denote examples of the first, second and third measured positions S1, S2 and S3 measured at the first, second, and third measurement positions P1, P2, and P3 of FIG. 4A respectively among the 31 transmittance spectra S1, S2, S3, ... Referring to FIG. 4B, the 31 transmittance spectrums S1, S2, S3, ... may be differently formed from 450 nm to 650 nm. These different transmittance spectra S1, S2, S3, ... may have a non-linear relation.

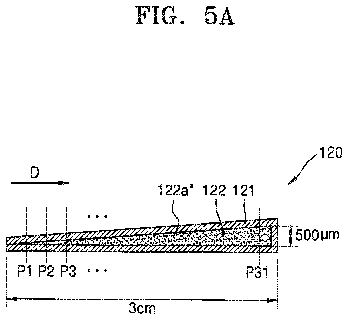

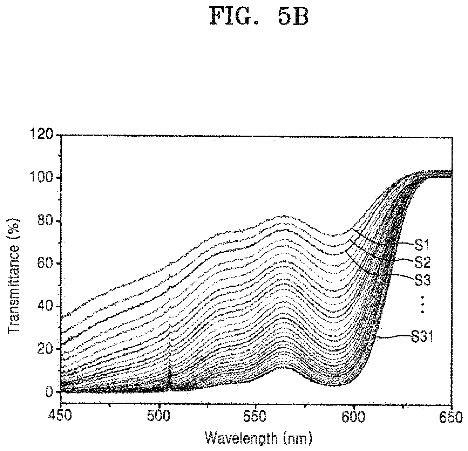

FIG. 5A illustrates another example of an experimental model of a light filter. FIG. 5B is a simulation result showing transmittance spectra of the light filter shown in FIG. 5A.

Referring to FIG. 5A, the liquid spectrum modulation layer 122 whose thickness varies according to different positions on the light filter is provided in an inner space of the filter frame 121. Here, a cyclohexane solution including a light absorption modulation material 122a" having a concentration of 3 wt% (weight percent) was used as the liquid spectrum modulation layer 122, and a quantum dot having a maximum absorption wavelength of 589 nm was used as the light absorption modulation material 122a". Such a liquid spectrum modulation layer 122 may have a triangular cross section whose thickness gradually increases along a D direction. In the spectrum modulation layer 122, the measurement positions P1, P2, P3, ..., P31 may be set at a regular distance along the D direction.

FIG. 5B shows the 31 different transmittance spectra S1, S2, S3, ..., S31 measured at the 31 measurement positions P1, P2, P3, ..., P31 set at the regular distance along the D direction in the spectrum modulation layer 122 of FIG. 5A. In FIG. 5B, S1, S2 and S3 denote examples of the first, second and third measured positions S1, S2 and S3 measured at the first, second, and third measurement positions P1, P2, and P3 of FIG. 5A, respectively, among the 31 transmittance spectra S1, S2, S3, ... Referring to FIG. 5B, the 31 transmittance spectrums S1, S2, S3, ... may be differently formed from 450 nm to 650 nm. These different transmittance spectra S1, S2, S3, ... may have a non-linear relation.

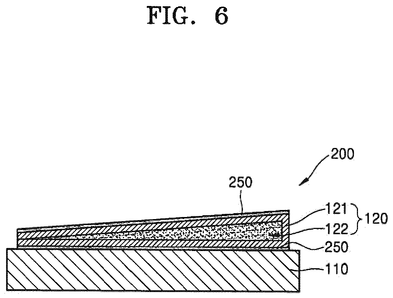

FIG. 6 is a cross-sectional view illustrating a spectrometer 200 according to another embodiment. The spectrometer 200 shown in FIG. 6 is the same as the spectrometer 100 shown in FIG. 1 except that an anti-reflection layer 250 is formed on a surface of the filter unit 120. Hereinafter, differences between the embodiment and the above-described embodiment will be mainly described.

Referring to FIG. 6, the spectrometer 200 includes the sensing unit 110 and a light filter provided on the sensing unit 110. The light filter includes the filter unit 120 and may include the anti-reflection layer 250 provided on the filter unit 120. The filter unit 120 includes the filter frame 121 and the liquid spectrum modulation layer 122 provided inside the filter frame 121. Here, the liquid spectrum modulation layer 122 has different thickness according to positions as described above.

The anti-reflection layer 250 may be provided on a lower surface and an upper surface of the filter frame 121. Here, the anti-reflection layer 250 provided on the upper surface of the filter frame 121 may prevent external light from being reflected from the upper surface of the filter frame 121. The anti-reflection layer 250 provided on the lower surface of the filter frame 121 may prevent light transmitted through the spectrum modulation layer 122 from being reflected from the lower surface of the filter frame 121. The anti-reflection layer 250 may be provided as a film or may be formed by processing the surface of the filter frame 121. Although FIG. 6 shows the case where the anti-reflection layer 250 is provided on the upper and lower surfaces of the filter frame 121, the anti-reflection layer 250 may be provided only on one of the upper and lower surfaces of the filter frame 121.

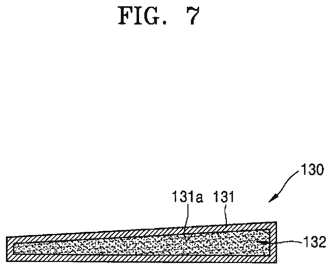

FIG. 7 is a cross-sectional view showing a light filter of a spectrometer according to another embodiment. Hereinafter, differences between the embodiment described in FIG. 7 and the above-described embodiments will be mainly described.

Referring to FIG. 7, the light filter includes a filter unit 130 having different transmittance spectra according to different positions on the light filter. The filter unit 130 includes a filter frame 131 and a liquid spectrum modulation layer 132 provided inside the filter frame 131.

The filter frame 131 includes an optically transparent material and may have an optically flat surface such that scattering does not occur. An inner space 131a of the filter frame 131 may be formed at different heights according to positions. Specifically, the inner space 131a of the filter frame 131 may have a trapezoidal cross section having a height gradually increasing in one direction.

The inner space 131a of the filter frame 131 is filled with the liquid spectrum modulation layer 132. Therefore, the liquid spectrum modulation layer 132 has a shape corresponding to the inner space 131a of the filter frame 131, that is, a trapezoidal cross section having a height gradually increasing in one direction.

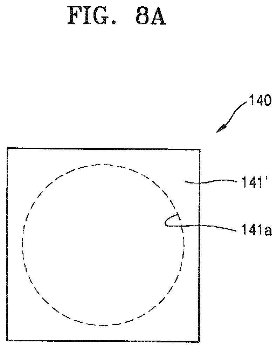

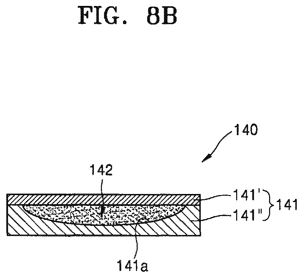

FIGS. 8A and 8B are a plan view and a cross-sectional view respectively showing a light filter of a spectrometer according to another embodiment. Hereinafter, differences between the embodiment in FIGS. 8A and 8B and the above-described embodiments will be mainly described.

Referring to FIGS. 8A and 8B, the light filter includes a filter unit 140 having different transmittance spectra according to positions. The filter unit 140 includes a filter frame 141 and a liquid spectrum modulation layer 142 provided inside the filter frame 141.

The filter frame 141 may include a base frame 141" formed with an inner space 141a and a cover frame 141' provided to cover the inner space 141a. The filter frame 141 includes an optically transparent material and may have an optically flat surface such that no scattering occurs. The inner space 141a of the filter frame 141 may be formed at different heights according to positions. Specifically, the inner space 141a of the filter frame 141 may have a lens-shaped cross section whose height gradually increases in one direction and then decreases again. The lens-shaped cross section may be a concave or convex shape.

The liquid spectrum modulation layer 142 is filled in the inner space 141a of the filter frame 141. Therefore, the liquid spectrum modulation layer 142 may have a lens-shaped cross section corresponding to the inner space 141a of the filter frame 141. The cross-sectional shapes of the spectrum modulation layers 122, 132, and 142 described above are merely examples, and the spectrum modulation layers 122, 132, and 142 may have various other cross-sectional shapes having thicknesses varying according to positions.

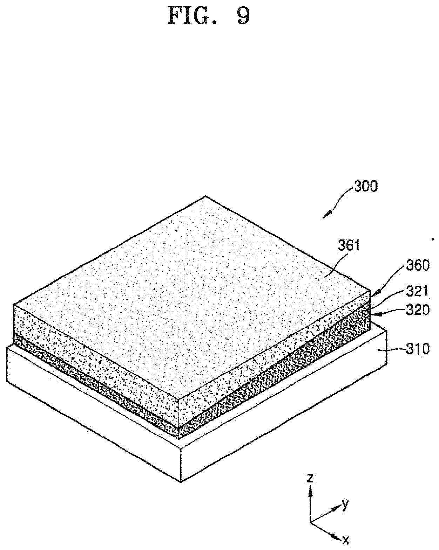

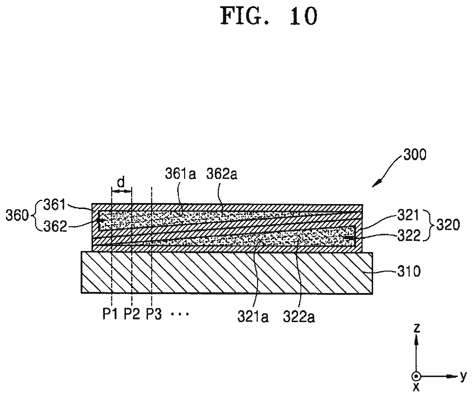

FIG. 9 is a perspective view showing a spectrometer 300 according to another embodiment. FIG. 10 is a cross-sectional view of the spectrometer 300 shown in FIG. 9.

Referring to FIGS. 9 and 10, the spectrometer 300 may include a sensing unit 310 and a light filter provided on the sensing unit 310. Here, the light filter may include a first filter unit 320 and a second filter unit 360 that are vertically stacked.

The first filter unit 320 may be provided on an upper surface of the sensing unit 310 and may have different transmittance spectra according to positions. The first filter unit 320 may include a first filter frame 321 and a liquid first spectrum modulation layer 322 provided inside the first filter frame 321. The second filter unit 360 may be provided on an upper surface of the first filter unit 320 and may have different transmittance spectra according to positions. The second filter unit 360 may include a second filter frame 361 and a liquid second spectrum modulation layer 362 provided inside the second filter frame 361.

The first and second filter frames 321 and 361 may include an optically transparent material. The first and second filter frames 321 and 361 may include, for example, glass, quartz, or polymer. The first and second filter frames 321 and 361 may have an optically flat surface such that no scattering occurs.

The first filter frame 321 may include an inner space 321a filled with the liquid first spectrum modulation layer 322. Here, the inner space 321a of the first filter frame 321 may be formed at different heights according to positions. For example, as shown in FIG. 10, the inner space 321a of the first filter frame 321 may have a triangular cross section whose height increases in the +y direction.

The liquid first spectrum modulation layer 322 may be filled in the inner space 321a of the first filter frame 321. Here, the liquid first spectrum modulation layer 322 may include a solution in which a first light absorption modulation material 322a is dispersed in a predetermined solvent. The first light absorption modulation material 322a may include at least one of, for example, QDs, inorganic materials, and polymers.

The liquid first spectrum modulation layer 322 may have a shape corresponding to the inner space 321a of the first filter frame 321. Therefore, the liquid first spectrum modulation layer 322 may have different thicknesses according to positions. For example, as shown in FIG. 10, the liquid first spectrum modulation layer 322 may have a triangular cross-sectional shape having thickness increasing along the +y direction.

The second filter frame 361 may include an inner space 361a in which the liquid second spectrum modulation layer 362 is filled. Here, the inner space 361a of the second filter frame 361 may be formed at different heights according to positions. For example, the internal space 361a of the second filter frame 361 may have a triangular cross section whose height gradually decreases along the +y direction.

The liquid second spectrum modulation layer 362 may be filled in the inner space 361a of the second filter frame 361. Here, the liquid second spectrum modulation layer 362 may include a solution in which a second light absorption modulation material 362a is dispersed in a predetermined solvent. The second light absorption modulation material 362a may be a material different from the first light absorption modulation material 322a. For instance, a type of the second light absorption modulation material 362a may be different from that of the first light absorption modulation material 322a or a size of the second light absorption modulation material 362a may be different from that of the first light absorption modulation material 322a. Such a second light absorption modulation material 362a may include at least one of, for example, QDs, inorganic materials, and polymers.

The liquid second spectrum modulation layer 362 may have a shape corresponding to the inner space 361a of the second filter frame 351. Therefore, the liquid second spectrum modulation layer 362 may have different thicknesses according to positions. For example, as shown in FIG. 10, the liquid second spectrum modulation layer 362 may have a triangular cross-sectional shape whose thickness gradually decreases along the +y direction.

In the embodiment, as described above, the light filter may include the first and second filter units 320 and 360 vertically stacked on the sensing unit 310. In the light filter including the vertically stacked first and second filter units 320 and 360, ratios of the first and second light absorption modulation materials 322a and 362a may be different according to the measurement positions P1, P2, P3, ... In FIG. 10, P1, P2, and P3 respectively denote the first, second, and third measurement positions set at a predetermined distance along the +y direction in the light filter.

In FIG. 10, the first spectrum modulation layer 322 may have the triangular cross section whose thickness increases along the +y direction, and the second spectrum modulation layer 362 may have the triangular cross section whose thickness decreases along the +y direction. In this case, when the measurement positions P1, P2, P3, ... of the light filter move in the +y direction, an amount of the first light absorption modulation material 322a may increase and an amount of the second light absorption modulation material 362a may increase. Therefore, the ratios of the first and second light absorption modulation materials 322a and 362a may be different according to the measurement positions P1, P2, P3, ... of the light filter.

On the other hand, in the light filter including the vertically stacked first and second filter units 320 and 360, the sum of the thicknesses of the first and second spectrum modulation layers 322 and 362 may be the same or different according to the measurement positions P1, P2, P3, ... For example, as shown in FIG. 10, when the thickness of the first spectrum modulation layer 322 increases along the +y direction and the thickness of the second spectrum modulation layer 362 decreases along the +y direction, the sum of the thicknesses of the first and second spectrum modulation layers 322 and 362 may be the same or different according to the measurement positions P1, P2, P3, ... of the light filter.

As described above, in the light filter in which the first and second filter units 320 and 360 are vertically stacked, different transmittance spectra may be obtained by varying the ratios of the first and second light absorption modulation materials 322a and 362a or by varying the thicknesses of the first and second spectrum modulation layers 322 and 362.

The first and second spectrum modulation layers 322 and 362 have been exemplarily described as having the triangular cross section above, but the disclosure is not limited thereto. The first and second spectrum modulation layers 322 and 362 may have a trapezoidal or lens type cross section or may have various other types of cross sections. The thickness of the first spectrum modulation layer 322 has been exemplarily described as increasing along the +y direction and the thickness of the second spectrum modulation layer 362 has been exemplarily described as decreasing along the +y direction, but the disclosure is not limited thereto. The thicknesses of the first and second spectrum modulation layers 322 and 362 may vary in various directions. The two first and second filter units 320 and 360 have been exemplarily described as being vertically stacked on the sensing unit 310 above, but the disclosure is not limited thereto. Three or more filter units may be vertically stacked on the sensing unit 310.

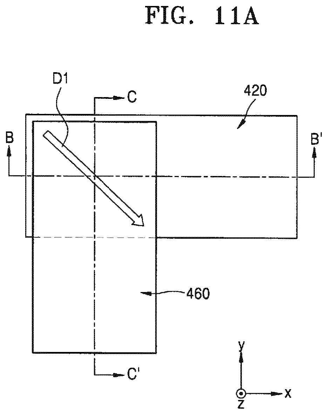

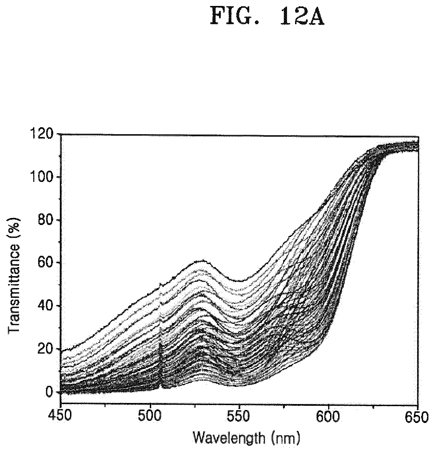

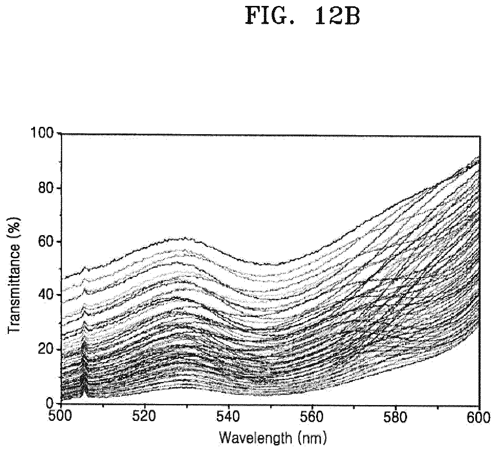

FIGS. 11A to 11C illustrate examples of an experimental model of a light filter. FIGS. 12A and 12B are simulation results showing transmittance spectra of the light filter shown in FIGS. 11A to 11C.

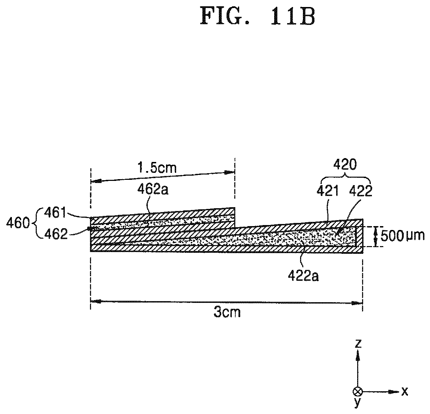

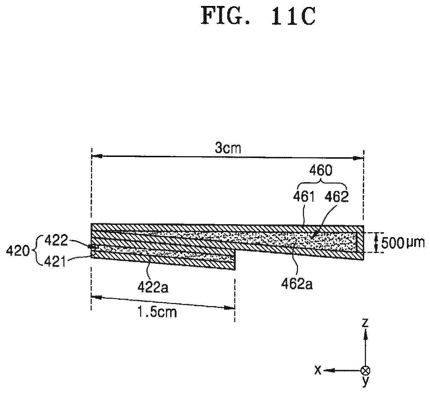

FIG. 11A shows a plan view of the light filter. FIG. 11B is a cross-sectional view taken along line B-B' of FIG. 11A. FIG. 11C is a cross-sectional view taken along line C-C' of FIG. 11A.

Referring to FIGS. 11A-11C, the light filter may include first and second vertically stacked filter units 420 and 460. Here, the first filter unit 420 may include a first filter frame 421 and a liquid first spectrum modulation layer 422 filled in an inner space of the first filter frame 421. As the first spectrum modulation layer 422, a cyclohexane solution including a first light absorption modulation material 422a of a concentration of 3 wt% was used. As the first light absorption modulation material 422a, QDs having a maximum absorption wavelength of 561 nm were used. The first filter unit 420 and the first spectrum modulation layer 422 may have a cross-sectional shape having thickness increasing along a +x direction.

The second filter unit 460 may include a second filter frame 461 and a liquid second spectrum modulation layer 462 filled in an inner space of the second filter frame 461. Here, a cyclohexane solution including a second absorption modulation material 462a of a concentration of 3 wt% was used as the second spectrum modulation layer 462, and QDs having a maximum absorption wavelength of 589 nm were used as the second absorption modulation material 462a. The second filter unit 460 and the second spectrum modulation layer 462 may have a cross-sectional shape having thickness increasing in a -y direction.

A part of the first filter unit 420 and a part of the second filter unit 460 may overlap each other. Specifically, a thin part of the first filter unit 420 and a thin part of the second filter unit 460 may overlap each other.

FIG. 12A shows a simulation result showing the transmittance spectra of the light filter shown in FIGS. 11A to 11C in a wavelength range of 450 nm to 650 nm. Specifically, FIG. 12A shows the transmittance spectra measured at 72 measurement positions set at a regular distance in a direction D1 in a region where the thin part of the first filter unit 420 and the thin part of the second filter unit 460 overlap each other. FIG. 12B shows the transmittance spectra by enlarging a wavelength range of 500 nm to 600 nm in FIG. 12A. Referring to FIGS. 12A and 12B, it may be seen that 72 transmittance spectrums are formed differently from each other. These different transmittance spectra may have a non-linear relation.

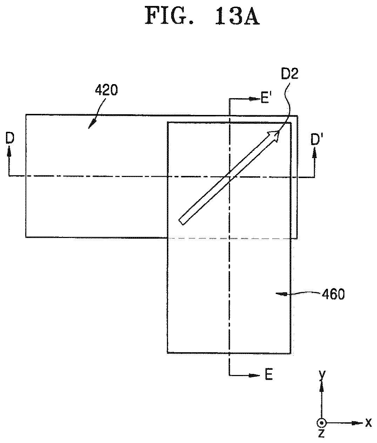

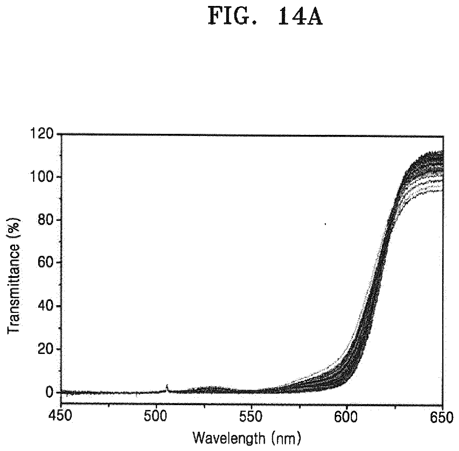

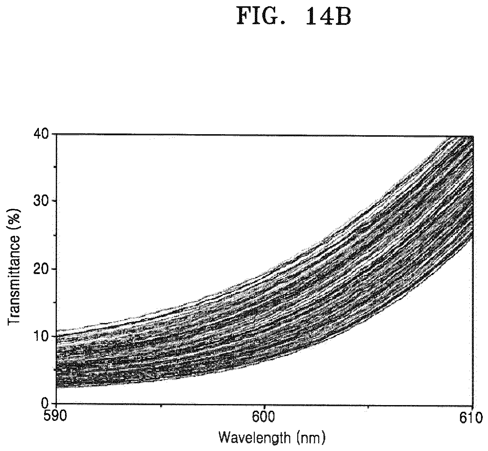

FIGS. 13A to 13C illustrate other examples of an experimental model of a light filter. FIGS. 14A and 14B are simulation results showing transmittance spectra of the light filter shown in FIGS. 13A to 13C.

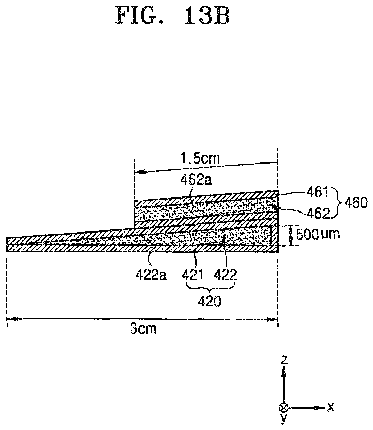

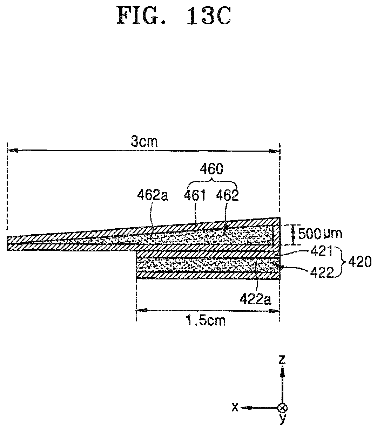

FIG. 13A shows a plan view of the light filter. FIG. 13B is a cross-sectional view taken along line D-D' in FIG. 13A. FIG. 13C is a cross-sectional view taken along line E-E' in FIG. 13A.

Referring to FIGS. 13A to 13C, the light filter may include first and second vertically stacked filter units 420 and 460. The first and second filter units 420 and 460 may be the same as the first and second filter units 420 and 460 shown in FIG. 11A. Here, the first filter unit 420 and the first spectrum modulation layer 422 may have a cross-sectional shape having a thickness increasing along the +x direction, and the second filter unit 460 and the second spectrum modulation layer 462 may have a cross-sectional shape having a thickness increasing along the +y direction. A part of the first filter unit 420 and a part of the second filter unit 460 may overlap each other. Specifically, a thick part of the first filter unit 420 and a thick part of the second filter unit 460 may overlap each other.

FIG. 14A shows the simulation result showing the transmittance spectra of the light filter shown in FIGS. 13A to 13C in a wavelength range of 450 nm to 650 nm. Specifically, FIG. 14A shows the transmittance spectrum measured at 120 measurement positions set at a regular distance in a direction D2 in a region where the thick part of the first filter unit 420 and the thick part of the second filter unit 460 overlap each other. FIG. 14B is an enlarged view of the transmittance spectra by enlarging a wavelength range of 590 nm to 610 nm in FIG. 12A. Referring to FIGS. 14A and 14B, it may be seen that 120 transmittance spectrums are formed differently from each other. These different transmittance spectra may have a non-linear relation.

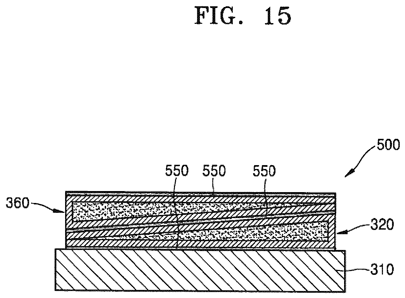

FIG. 15 is a cross-sectional view of a spectrometer 500 according to another embodiment. The spectrometer 500 shown in FIG. 15 is the same as the spectrometer 300 shown in FIG. 9 except that anti-reflection layers 550 are formed on the vertically stacked first and second filter units 320 and 360. Hereinafter, differences between the embodiment and the above-described embodiment will be mainly described.

Referring to FIG. 15, the spectrometer 500 may include a sensing unit 310 and a light filter provided on the sensing unit 310. The light filter may include the first and second filter units 320 and 360 vertically stacked on the sensing unit 310 and the plurality of anti-reflection layers 550 provided on the first and second filter units 320 and 360. Here, the first and second filter units 320 and 360 may have different thicknesses according to positions as described above.

The anti-reflection layers 550 may be provided on a lower surface of the first filter unit 320, on an upper surface of the second filter unit 360, and between the first and second filter units 320 and 360, respectively. Meanwhile, the anti-reflection layers 550 may be provided on at least one of the lower surface of the first filter unit 320, the upper surface of the second filter unit 360, and between the first and second filter units 320 and 360.

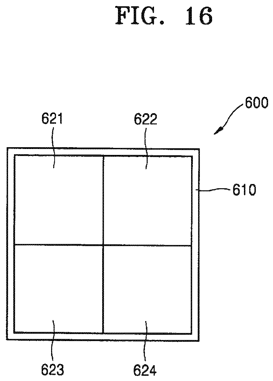

FIG. 16 is a plan view showing a spectrometer 600 according to another embodiment.

Referring to FIG. 16, the spectrometer 600 may include a sensing unit 610 and a light filter provided on the sensing unit 610. Here, the light filter may include a plurality of filter units 621, 622, 623, and 624 arranged in an array on the sensing unit 610. Each of the filter units 621, 622, 623, and 624 may have different thicknesses according to positions as described above.

FIG. 16 shows the example in which the four filter units 621, 622, 623, and 624 are arranged in a two-dimensional (2D) array on an upper surface of the sensing unit 610, but the disclosure is not limited thereto. The number of filter units arranged on the sensing unit 610 and an arrangement shape of the filter units may be variously modified.

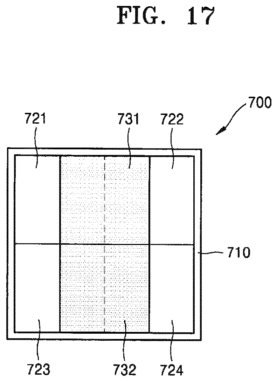

FIG. 17 is a plan view showing a spectrometer 700 according to another embodiment.

Referring to FIG. 17, the spectrometer 700 may include a sensing unit 710 and a light filter provided on the sensing unit 710. Here, the light filter may include a plurality of filter units 721, 722, 723, 724, 731, and 732 arranged horizontally and vertically on the sensing unit 710. Here, each of the filter units 721, 722, 723, 724, 731, and 732 may have different thicknesses according to positions as described above.

FIG. 17 shows the example in which the four filter units 721, 722, 723, and 724 are arranged in a 2D array on an upper surface of the sensing unit 710 and the two filter units 731 and 732 are stacked on an upper portion of the four filter units 721, 722, 723, and 724, but the disclosure is not limited thereto. The number of filter units arranged on the sensing unit 710 and an arrangement shape of the filter units may be variously modified.

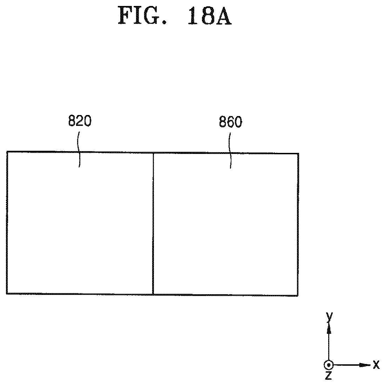

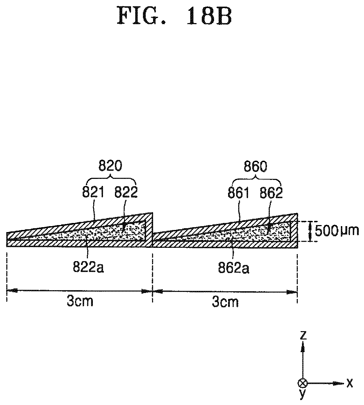

FIGS. 18A and 18B show examples of an experimental model of a light filter. FIG. 18A is a plan view of the light filter. FIG. 18B is a cross-sectional view of the light filter.

Referring to FIGS. 18A and 18B, the light filter may include first and second filter units 820 and 860 horizontally arranged on the same plane. Here, the first filter unit 820 may include a first filter frame 821 and a liquid first spectrum modulation layer 822 filled in an inner space of the first filter frame 821. As the first spectrum modulation layer 822, a cyclohexane solution including a first light absorption modulation material 822a of a concentration of 3 wt% was used. As the first light absorption modulation material 822a, QDs having a maximum absorption wavelength of 561 nm were used. The first filter unit 820 and the first spectrum modulation layer 822 may have a cross-sectional shape having thickness increasing along the +x direction.

The second filter unit 860 may include a second filter frame 861 and a liquid second spectrum modulation layer 862 filled in an inner space of the second filter frame 861. As the second spectrum modulation layer 862, a cyclohexane solution including a second light absorption modulation material 862a of a concentration of 3 wt% was used. As the second light absorption modulation material 862a, QDs having a maximum absorption wavelength of 589 nm were used. The second filter unit 860 and the second spectrum modulation layer 862 may have a cross-sectional shape having thickness increasing along the +x direction.

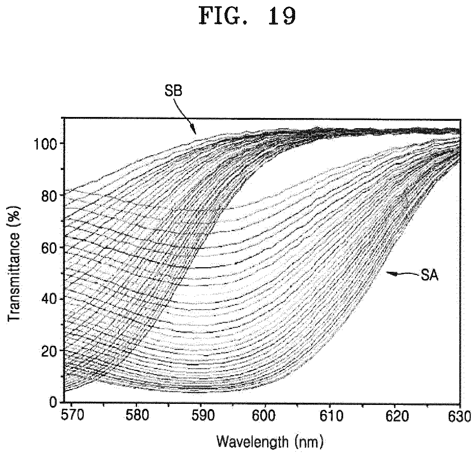

FIG. 19 is a simulation result showing transmittance spectrums SB and SA of a light filter shown in FIGS. 18A and 18B in a wavelength range of 570 nm to 630 nm. Specifically, FIG. 19 shows the transmittance spectrums SB measured at 31 measurement positions set at a regular distance along the +x direction in the first filter unit 820 and the transmittance spectra SB measured at 31 measurement positions set at a regular distance along the +x direction in the first filter unit 820. Referring to FIG. 19, it may be seen that the 31 different transmittance spectrums SB are formed by the first filter unit 820, and the 31 different transmittance spectrums SA are formed by the second filter unit 860.

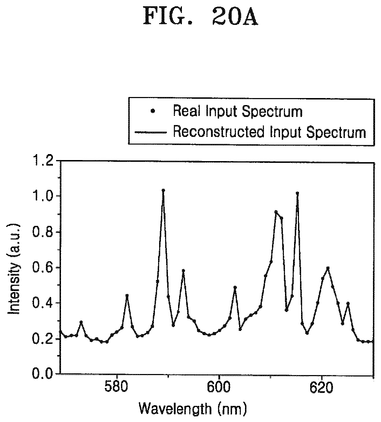

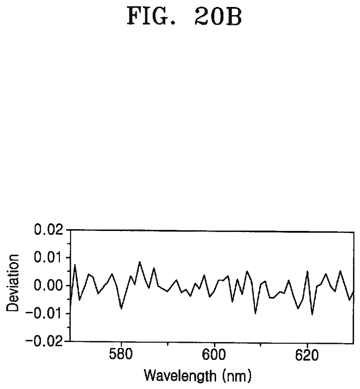

FIGS. 20A and 20B show comparisons between a reconstructed input spectrum and a real input spectrum from a result shown in FIG. 19. Here, the reconstructed input spectrum may be calculated using Equation (1) described above. This is also the same hereinafter.

Referring to FIGS. 20A and 20B, it may be seen that a deviation between the real input spectrum and the reconstructed input spectrum is as small as about 1% such that the reconstructed input spectrum substantially coincides with the real input spectrum of a light filter. Thus, the reconstructed input spectrum with high accuracy may be obtained, and the real input spectrum may be accurately measured from the reconstructed input spectrum.

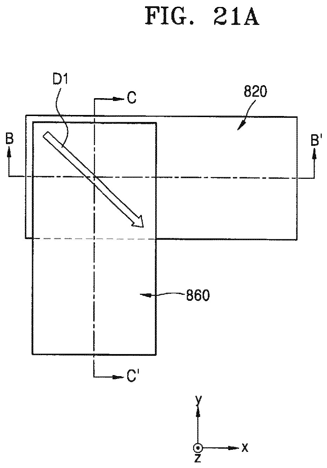

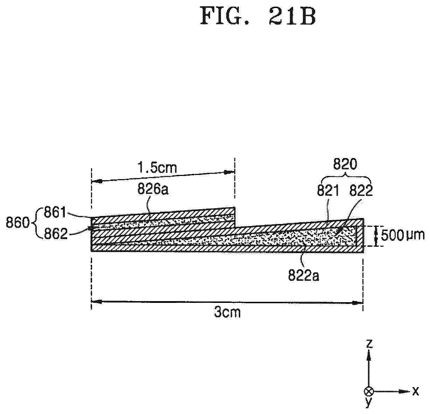

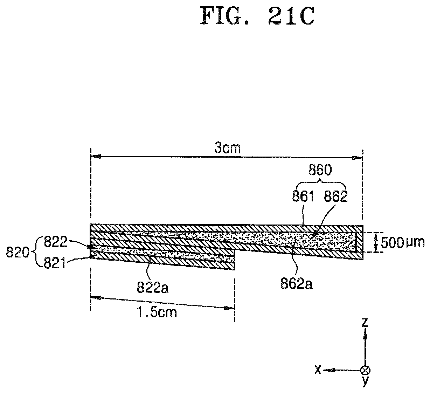

FIGS. 21A to 21C illustrate other examples of an experimental model of a light filter. FIG. 21A shows a plan view of the light filter. FIG. 21B is a cross-sectional view taken along line B-B' of FIG. 21A. FIG. 21C is a cross-sectional view taken along line C-C' of FIG. 21A.

Referring to FIGS. 21A to 21C, the light filter may include the vertically stacked first and second filter units 820 and 860. The first and second filter units 820 and 860 are the same as the first and second filter units shown in FIGS. 18A and 18B. Here, the first filter unit 820 and the first spectrum modulation layer 822 may have a cross-sectional shape having thickness increasing along the +x direction. The second filter unit 860 and the second spectrum modulation layer 862 may have a cross-sectional shape having thickness increasing along the -y direction. A part of the first filter unit 820 and a part of the second filter unit 860 may overlap each other. Specifically, a thin part of the first filter unit 820 and a thin part of the second filter unit 860 may overlap each other.

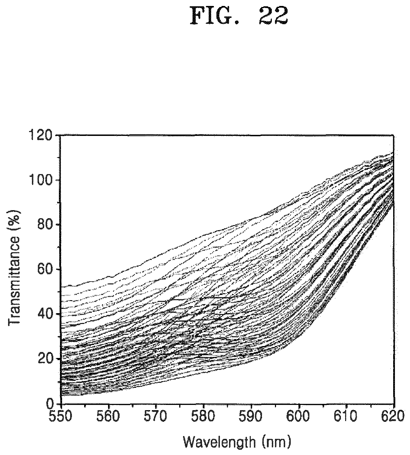

FIG. 22 shows a simulation result showing transmittance spectra of light filters shown in FIGS. 11A to 11C in a wavelength range of 550 nm to 620 nm. Specifically, FIG. 22 shows the transmittance spectra measured at 72 measurement positions set at a regular distance along the direction D1 in a region where a thin part of the first filter unit 820 and a thin part of the second filter unit 860 overlap. Referring to FIG. 22, it may be seen that the 72 transmittance spectrums are formed differently from each other.

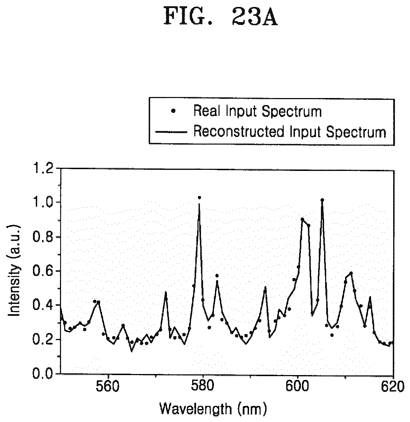

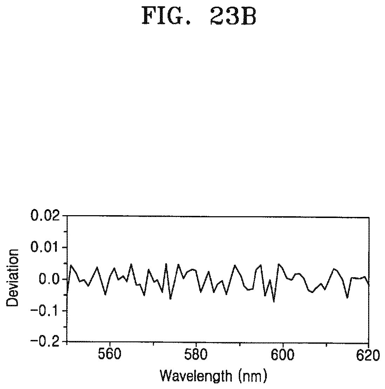

FIGS. 23A and 23B show comparisons between a reconstructed input spectrum and a real input spectrum from a result shown in FIG. 22.

Referring to FIGS. 23A and 23B, it may be seen that a deviation between the real input spectrum and the reconstructed input spectrum is as small as about 5% such that the reconstructed input spectrum almost coincides with the real input spectrum of a light filter. Thus, the reconfigured input spectrum with high accuracy may be obtained, and the real input spectrum may be accurately measured from the reconstructed input spectrum.

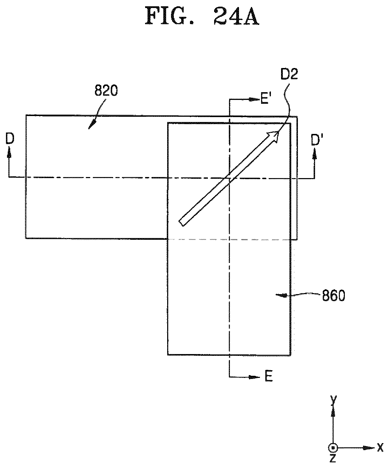

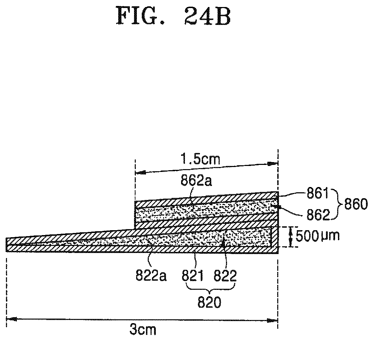

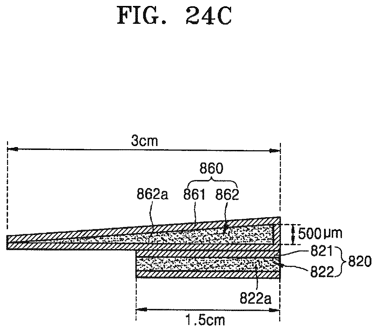

FIGS. 24A to 24C illustrate other examples of an experimental model of a light filter. FIG. 24A is a plan view of the light filter. FIG. 24B is a cross-sectional view taken along line D-D' in FIG. 24A. FIG. 24C is a cross-sectional view taken along line E-E' in FIG. 24A.

Referring to FIGS. 24A to 24C, the light filter may include the first and second vertically stacked filter units 820 and 860. The first and second filter units 820 and 860 are the same as the first and second filter units 820 and 860 shown in FIGS. 18A and 18B. Here, the first filter unit 820 and the first spectrum modulation layer 822 may have a cross-sectional shape having thickness increasing along the +x direction, and the second filter unit 860 and the second spectrum modulation layer 862 may have a cross-sectional shape having thickness increasing along the +y direction. A part of the first filter unit 820 and a part of the second filter unit 860 may overlap each other. Specifically, a thick part of the first filter unit 820 and a thick part of the second filter unit 860 may overlap each other.

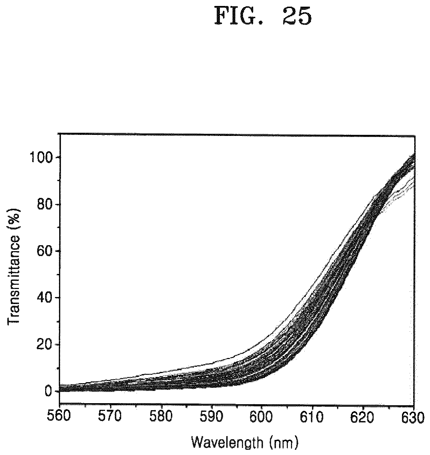

FIG. 25 shows a simulation result showing transmittance spectra of a light filter shown in FIGS. 24A to 24C in a wavelength range of 560 nm to 630 nm. Specifically, FIG. 25 shows the transmittance spectra measured at 120 measurement positions set at a regular distance along the direction D2 in a region where the thick part of the first filter unit 820 and the thick part of the second filter unit 860 overlap. Referring to FIG. 25, it may be seen that the 120 transmittance spectrums are formed differently.

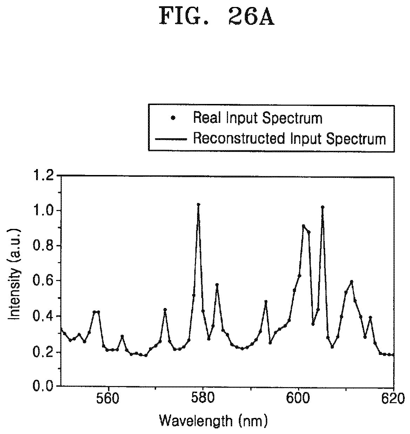

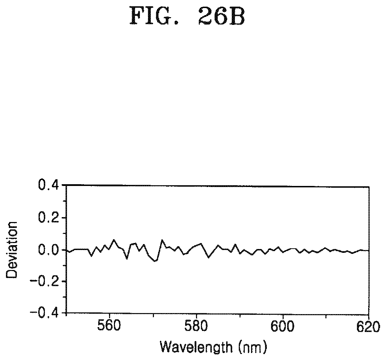

FIGS. 26A and 26B show comparisons between a reconstructed input spectrum and a real input spectrum from a result shown in FIG. 25.

Referring to FIGS. 26A and 26B, it may be seen that a deviation between the real input spectrum and the reconstructed input spectrum is as small as about 0.5% such that the reconstructed input spectrum almost coincides with the real input spectrum of a light filter. Thus, the reconfigured input spectrum with high accuracy may be obtained, and the real input spectrum may be accurately measured from the reconstructed input spectrum.

According to the above embodiments, different transmittance spectrums may be formed by varying a thickness of a spectrum modulation layer according to positions. For example, when 100 or more different transmittance spectra are formed within a wavelength range of 100 nm, a spectrometer having a high resolution of about 1 nm or less may be realized.

Further, the thickness of the spectrum modulation layer may be easily adjusted by manufacturing a light filter using a filter frame and a liquid spectrum modulation layer. Also, the liquid spectrum modulation layer may precisely adjust the thickness according to positions, and thus precisely modulated transmittance spectra may be obtained. Further, since the filter frame has an optically flat surface that does not cause scattering, and a liquid spectrum modulation layer may include a solvent that does not cause scattering, a spectrometer having excellent optical characteristics may be realized.

It should be understood that embodiments described herein should be considered in a descriptive sense only and not for purposes of limitation. Descriptions of features or aspects within each embodiment should typically be considered as available for other similar features or aspects in other embodiments.

While one or more embodiments have been described with reference to the figures, it will be understood by those of ordinary skill in the art that various changes in form and details may be made therein. The invention is defined by the appended claims.

**Claims**

1. A spectrometer comprising:

> a light filter; and
> a sensing unit (110) configured to receive light transmitted through the light filter, wherein the sensing unit comprises an image sensor, and

wherein the light filter is provided on the sensing unit and comprises at least one filter (120), wherein the at least one filter comprises:

(a) a liquid spectrum modulation layer (122) having different transmittance spectra according to different positions on the at least one filter, wherein the liquid spectrum modulation layer has different thicknesses according to the different positions on the at least one filter, and wherein the liquid spectrum modulation layer comprises a solution comprising a light absorption modulation material (122a) dispersed in a predetermined solvent; and

(b) a filter frame (121) comprising an inner space (121a) filled with the liquid spectrum modulation layer, wherein the filter frame is formed of an optically transparent material, and wherein the liquid spectrum modulation layer has a shape corresponding to the inner space of the filter frame.

2. The spectrometer of claim 1, wherein the filter frame comprises glass, quartz, or polymer.

3. The spectrometer of claim 2, wherein the inner space of the filter frame comprises a triangular, trapezoidal, or lens shaped cross section.

4. The spectrometer of claim 1, wherein the light absorption modulation material comprises at least one of quantum dots, QDs, inorganic materials, or polymers.

5. The spectrometer of claim 1, wherein the different transmittance spectra are differently formed from 450 nm to 650 nm and have a non-linear relation.

6. The spectrometer of claim 1, further comprising an anti-reflection layer provided on at least one of an upper surface and a lower surface of the at least one filter.

7. The spectrometer of claim 1, wherein the at least one filter further comprises a plurality of filters,

wherein each of the plurality of filters comprises a respective liquid spectrum modulation layer, and
wherein the plurality of filters are arranged in an array on a same plane.

8. The spectrometer of claim 7, wherein the respective liquid spectrum modulation layers of the plurality of filters have different types of light absorption modulation materials or different sizes of light absorption modulation materials.

9. The spectrometer of claim 1, wherein the at least one filter further comprises a plurality of filters,

wherein each of the plurality of filters comprises a respective liquid spectrum modulation layer, and
wherein the plurality of filters are arranged in a vertically overlapping form.

10. The spectrometer of claim 9, wherein the respective liquid spectrum modulation layers of the plurality of filters have different types of light absorption modulation materials or different sizes of light absorption modulation materials.

11. The spectrometer of claim 10, wherein ratios of the light absorption modulation materials at the different positions of the light filter are different according to a characteristic of overlapping filters, among the plurality of overlapping filters, at the different positions of the light filter.

12. The spectrometer of claim 1, wherein the at least one filter further comprises a plurality of filters,

wherein each of the plurality of filters comprises a respective liquid spectrum modulation layer, and
wherein the plurality of filters are arranged in an array on a same plane and are arranged in a vertically overlapping form.

13. The spectrometer of claim 1, wherein the sensor comprises an image sensor or a photodiode; and/or
wherein the spectrometer has a resolution less than or equal to 1 nm.

**Patentansprüche**

1. Spektrometer, umfassend:

   ein Lichtfilter; und
   eine Erfassungseinheit (110), ausgebildet zum Empfangen durch das Lichtfilter übertragenes Licht, wobei die Erfassungseinheit einen Bildsensor umfasst, und
   wobei das Lichtfilter an der Erfassungseinheit angeordnet ist und wenigstens ein Filter (120) umfasst, wobei das wenigstens eine Filter umfasst:

   (a) eine flüssige Spektrummodulationsschicht (122) mit unterschiedlichen Durchlässigkeitsspektren gemäß unterschiedlichen Positionen auf dem wenigstens einen Filter, wobei die flüssige Spektrumsmodulationsschicht unterschiedliche Dicken entsprechend den unterschiedlichen Positionen auf dem wenigstens einen Filter aufweist und wobei die flüssige Spektrumsmodulationsschicht eine Lösung umfasst, umfassend ein Lichtabsorptionsmodulationsmaterial (122a), dispergiert in einem vorbestimmten Lösemittel; und
   (b) einen Filterrahmen (121), umfassend einen Innenraum (121a), gefüllt mit der flüssigen Spektrumsmodulationsschicht, wobei der Filterrahmen aus einem optisch transparenten Material gebildet ist und wobei die flüssige Spektrumsmodulationsschicht eine dem Innenraum des Filterrahmens entsprechende Form aufweist.

2. Spektrometer nach Anspruch 1, wobei der Filterrahmen Glas, Quarz oder Polymer umfasst.

3. Spektrometer nach Anspruch 2, wobei der Innenraum des Filterrahmens einen dreieckigen, trapezförmigen oder linsenförmigen Querschnitt umfasst.

4. Spektrometer nach Anspruch 1, wobei das Lichtabsorptionsmodulationsmaterial wenigstens ein Element der Gruppe umfassend Quantenpunkte, QDs, anorganische Materialien und Polymere umfasst.

5. Spektrometer nach Anspruch 1, wobei die unterschiedlichen Durchlässigkeitsspektren von 450 nm bis 650 nm unterschiedlich gebildet sind und eine nicht-lineare Beziehung aufweisen.

6. Spektrometer nach Anspruch 1, ferner umfassend eine Antireflexionsschicht, angeordnet wenigstens auf einer Oberseite oder einer Unterseite des wenigstens einen Filters.

7. Spektrometer nach Anspruch 1, wobei das wenigstens eine Filter ferner eine Vielzahl von Filtern umfasst,

   wobei jedes der Vielzahl von Filtern eine entsprechende flüssige Spektrumsmodulationsschicht umfasst, und
   wobei die Vielzahl von Filtern in einer Gruppe auf der gleichen Ebene angeordnet ist.

8. Spektrometer nach Anspruch 7, wobei die jeweiligen flüssigen Spektralmodulationsschichten der Vielzahl von Filtern unterschiedliche Arten von Lichtabsorptionsmodulationsmaterialien oder unterschiedliche Größen von Lichtabsorptionsmodulationsmaterialien aufweisen.

9. Spektrometer nach Anspruch 1, wobei das wenigstens eine Filter ferner eine Vielzahl von Filtern umfasst,

   wobei jedes der Vielzahl von Filtern eine entsprechende flüssige Spektrumsmodulationsschicht umfasst, und
   wobei die Vielzahl der Filter in einer vertikal überlappenden Form angeordnet ist.

10. Spektrometer nach Anspruch 9, wobei die jeweiligen flüssigen Spektralmodulationsschichten der Vielzahl von Filtern unterschiedliche Arten von Lichtabsorptionsmodulationsmaterialien oder unterschiedliche Größen von Lichtabsorptionsmodulationsmaterialien aufweisen.

11. Spektrometer nach Anspruch 10, wobei die Verhältnisse der Lichtabsorptionsmodulationsmaterialien an den verschiedenen Positionen des Lichtfilters entsprechend einer Charakteristik von überlappenden Filtern aus der Vielzahl von überlappenden Filtern an den verschiedenen Positionen des Lichtfilters unterschiedlich sind.

12. Spektrometer nach Anspruch 1, wobei das wenigstens eine Filter ferner eine Vielzahl von Filtern umfasst,

wobei jedes der Vielzahl von Filtern eine entsprechende flüssige Spektrumsmodulationsschicht umfasst, und wobei die Vielzahl von Filtern in einer Gruppe auf einer gleichen Ebene und in einer vertikal überlappenden Form angeordnet ist.

13. Spektrometer nach Anspruch 1, wobei der Sensor einen Bildsensor oder eine Fotodiode umfasst; und/oder wobei das Spektrometer eine Auflösung von 1 nm oder weniger aufweist.

**Revendications**

1. Spectromètre comprenant :

   un filtre de lumière ; et
   une unité de détection (110) configurée pour recevoir la lumière qui est transmise au travers du filtre de lumière, dans lequel l'unité de détection comprend un capteur d'image ; et
   dans lequel le filtre de lumière est prévu sur l'unité de détection et comprend au moins un filtre (120), et dans lequel l'au moins un filtre comprend :

      (a) une couche de modulation de spectre liquide (122) qui présente des spectres de transmittance différents en fonction de positions différentes sur l'au moins un filtre, dans lequel la couche de modulation de spectre liquide présente des épaisseurs différentes en fonction des positions différentes sur l'au moins un filtre, et dans lequel la couche de modulation de spectre liquide comprend une solution qui comprend un matériau de modulation d'absorption de lumière (122a) qui est dispersé dans un solvant prédéterminé ; et
      (b) une structure de filtre (121) comprenant un espace interne (121a) qui est rempli par la couche de modulation de spectre liquide, dans lequel la structure de filtre est formée à partir d'un matériau optiquement transparent et dans lequel la couche de modulation de spectre liquide présente une forme qui correspond à l'espace interne de la structure de filtre.

2. Spectromètre selon la revendication 1, dans lequel la structure de filtre comprend du verre, du quartz ou un/des polymère(s).

3. Spectromètre selon la revendication 2, dans lequel l'espace interne de la structure de filtre comprend une section en coupe transversale triangulaire, trapézoïdale ou en forme de lentille.

4. Spectromètre selon la revendication 1, dans lequel le matériau de modulation d'absorption de lumière comprend au moins un matériau parmi des points quantiques, à savoir des QD, des matériaux inorganiques et des polymères.

5. Spectromètre selon la revendication 1, dans lequel les spectres de transmittance différents sont formés différemment de 450 nm à 650 nm et ils présentent une relation non linéaire.

6. Spectromètre selon la revendication 1, comprenant en outre une couche antireflet qui est prévue sur au moins une surface parmi une surface supérieure et une surface inférieure de l'au moins un filtre.

7. Spectromètre selon la revendication 1, dans lequel :
   l'au moins un filtre comprend en outre une pluralité de filtres ; dans lequel :
   chacun de la pluralité de filtres comprend une couche de modulation de spectre liquide respective ; et dans lequel :
   les filtres de la pluralité de filtres sont agencés selon un réseau sur un même plan.

8. Spectromètre selon la revendication 7, dans lequel les couches de modulation de spectre liquides respectives de la pluralité de filtres comportent des types différents de matériaux de modulation d'absorption de lumière ou présentent des dimensions différentes de matériaux de modulation d'absorption de lumière.

9. Spectromètre selon la revendication 1, dans lequel :
   l'au moins un filtre comprend en outre une pluralité de filtres ; dans lequel :
   chacun de la pluralité de filtres comprend une couche de modulation de spectre liquide respective ; et dans lequel :
   les filtres de la pluralité de filtres sont agencés selon une forme en chevauchement verticalement.

10. Spectromètre selon la revendication 9, dans lequel les couches de modulation de spectre liquides respectives de la pluralité de filtres comportent des types différents de matériaux de modulation d'absorption de lumière ou présentent des dimensions différentes de matériaux de modulation d'absorption de lumière.

11. Spectromètre selon la revendication 10, dans lequel des rapports des matériaux de modulation d'absorption de lumière au niveau des positions différentes du filtre de lumière sont différents en fonction d'une caractéristique de filtres en chevauchement, parmi la pluralité de filtres en chevauchement, au niveau des positions différentes du filtre de lumière.

12. Spectromètre selon la revendication 1, dans lequel :
l'au moins un filtre comprend en outre une pluralité de filtres ; dans lequel :
chacun de la pluralité de filtres comprend une couche de modulation de spectre liquide respective ; et dans lequel :
les filtres de la pluralité de filtres sont agencés selon un réseau sur un même plan et sont agencés selon une forme en chevauchement verticalement.

13. Spectromètre selon la revendication 1, dans lequel :
le capteur comprend un capteur d'image ou une photodiode ; et/ou dans lequel :
le spectromètre présente une résolution inférieure ou égale à 1 nm.

FIG. 1

# FIG. 2

# FIG. 3

# FIG. 4A

# FIG. 4B

# FIG. 5A

FIG. 5B

FIG. 6

FIG. 7

FIG. 8A

FIG. 8B

FIG. 9

# FIG. 10

FIG. 11A

# FIG. 11B

# FIG. 11C

FIG. 12A

FIG. 12B

## FIG. 13A

# FIG. 13B

# FIG. 13C

FIG. 14A

FIG. 14B

FIG. 15

FIG. 16

FIG. 17

# FIG. 18A

# FIG. 18B

FIG. 19

# FIG. 20A

# FIG. 20B

FIG. 21A

# FIG. 21B

# FIG. 21C

FIG. 22

# FIG. 23A

...

## FIG. 23B

# FIG. 24A

FIG. 24B

FIG. 24C

FIG. 25

# FIG. 26A

# FIG. 26B

**EP 3 617 675 B1**

**Patent documents cited in the description**

- US 6573988 B1